## Europäisches Patentamt
## European Patent Office
## Office européen des brevets

(19)

(11) Veröffentlichungsnummer: **0 106 088**
**B1**

(12)                    EUROPÄISCHE PATENTSCHRIFT

(45) Veröffentlichungstag der Patentschrift:
**10.12.86**

(51) Int. Cl.⁴: **H 03 F 3/45**

(21) Anmeldenummer: **83108589.9**

(22) Anmeldetag: **31.08.83**

(54) Halbleiter-Verstärkerschaltung.

(30) Priorität: **16.09.82 DE 3234400**

(43) Veröffentlichungstag der Anmeldung:
**25.04.84 Patentblatt 84/17**

(45) Bekanntmachung des Hinweises auf die Patenterteilung:
**10.12.86 Patentblatt 86/50**

(84) Benannte Vertragsstaaten:
**AT DE FR GB IT**

(56) Entgegenhaltungen:
**DE - A - 2 613 652**

**IEEE TRANSACTIONS ON CONSUMER ELECTRONICS,
Band CE-24, Nr. 3, August 1978 C. CINI et al. "Better
internal protection and fewer leads mark new
generation of integrated L-F power amplifiers"**

(73) Patentinhaber: **Siemens Aktiengesellschaft Berlin und
München, Wittelsbacherplatz 2, D-8000 München 2 (DE)**

(72) Erfinder: **Lenz, Michael, Ing. grad., Fischbachauer
Strasse 3, D-8000 München 90 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Halbleiter-Verstärkerschaltung, insbesondere eine Halbleiter-Leistungsverstärkerschaltung nach dem Oberbegriff des Patentanspruchs 1.

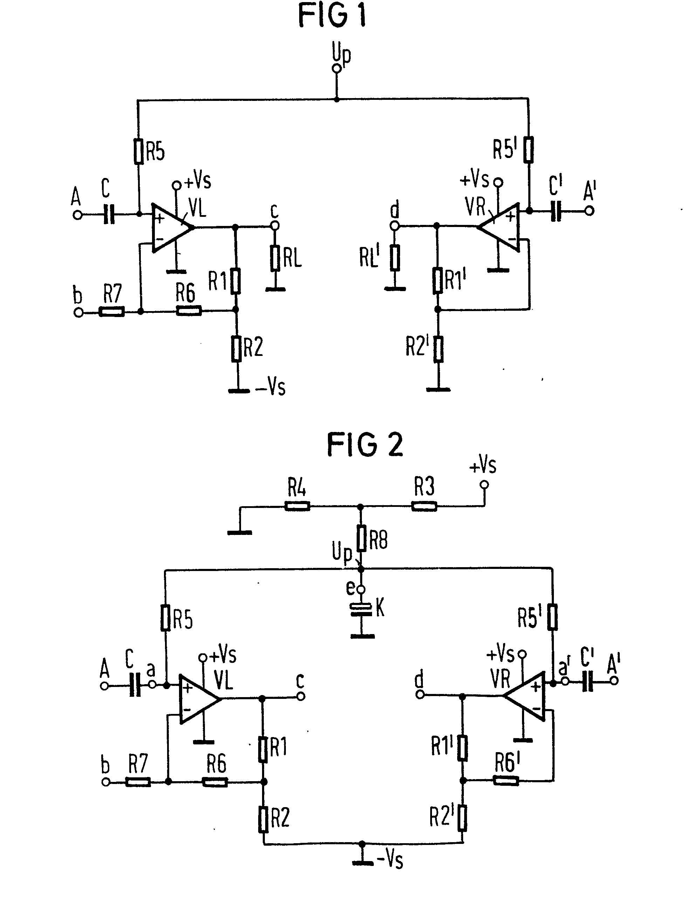

Eine bekannte Schaltung dieser Art ist in Figur 1 dargestellt. Sie enthält die beiden – einander im Aufbau gleichen – Operationsverstärker $V_L$ und $V_R$, deren nichtinvertierender Eingang, wie üblich, durch das «+»-Zeichen und deren invertierender Eingang durch das «−»-Zeichen gekennzeichnet ist. Der Ausgang c des einen Operationsverstärkers $V_L$ ist über die Reihenschaltung zweier Widerstände $R_1$ und $R_6$ mit dem invertierenden Eingang dieses Operationsverstärkers verbunden. Der zwischen den beiden Widerständen $R_1$ und $R_6$ gegebene Teilerpunkt ist ausserdem über einen – zusammen mit dem Widerstand $R_1$ einen Spannungsteiler gemäss der oben gegebenen Definition bildenden – Widerstand $R_2$ an das Bezugspotential $-V_s$ angeschlossen. Ein Gegenkopplungsnetzwerk dieser Gestalt ermöglicht den invertierenden Betrieb des Verstärkers $V_L$, wie er für Brückenverstärker unerlässlich ist. Man steuert dazu über die Klemme b und den Widerstand $R_7$ den invertierenden Signaleingang des Operationsverstärkers $V_L$ an.

In entsprechender Weise ist bei dem anderen Operationsverstärker $V_R$ der Signalausgang über die Reihenschaltung zweier Widerstände $R_1'$ und $R_2'$ ebenfalls mit dem Bezugspotential $- V_s$ verbunden. Durch eine unmittelbare Verbindung zwischen dem Teilerpunkt der beiden Widerstände $R_1'$ und $R_2'$ und dem invertierenden Signaleingang des Operationsverstärkers $V_R$ ist in diesem Fall die Gegenkopplung gegeben. Sie ist also im Falle des Operationsverstärkers $V_R$ einfacher als im Falle des Operationsverstärkers $V_L$.

Die nichtinvertierenden Signaleingänge beider Operationsverstärker $V_L$ und $V_R$ liegen, z.B. unter Vermittlung je eines Kondensators C bzw. C', an je einem Signaleingang A bzw. A' der Verstärkerschaltung. Ausserdem sind die beiden Eingänge A und A' über je einen Versorgungswiderstand $R_5$ bzw. $R_5'$ an einen gemeinsamen Anschluss zwecks Beaufschlagung mit einem abgeleiteten Versorgungspotential $U_P$ gelegt. Der Signalausgang des Operationsverstärkers $V_L$ arbeitet über die Klemme c auf ein Lastelement $R_L$ und der Signalausgang des Operationsverstärkers $V_R$ über die Klemme d auf ein Lastelement $R_L'$. Beide Lastelemente können verschieden sein, z.B. wenn die Verstärkerschaltung als Stereoverstärker betrieben wird. Sie können aber auch durch ein einziges Lastelement, z.B. einen Lautsprecher, gegeben sein. Die beiden Verstärkerausgänge c und d arbeiten dann auf je einen Anschluss des gemeinsamen Lastelements. In diesem Falle ist die Verstärkerschaltung als Brückenschaltung betrieben.

Um nun allgemein einen solchen Stereo-Brückenverstärker mit reeller Gegenkopplung aufzubauen braucht man somit, wie aus Figur 1 ersichtlich, eine Reihe äusserer Widerstände und weiterer Bauelemente. Da aber noch zusätzlich im allgemeinen ein Offsetabgleich erforderlich sein wird, ist eine integrierte Realisierung der in Figur 1 dargestellten Kombination der beiden Operationsverstärker praktisch undurchführbar.

Aus der DE-AS 26 13 652 und IEEE Trans. Cunsumer Electron. Vol. CE-24, No. 3, 1978, pp 328–335 sind integrierfähige Brückenverstärkerschaltungen bekannt, die aber keine reelle Gegenkopplung besitzen und bei grossen Spannungsänderungen aufgrund ihrer unterschiedlichen Verstärkungsfaktoren hinsichtlich des AC- und DC-Verhaltens zu einer hohen Beanspruchung der Last führen. Sie sind ausserdem durch die Serienschaltung ihrer Operationsverstärker insbesondere für Leistungsverstärker klirrfaktormässig nachteilig.

Der Erfindung liegt die Aufgabe zugrunde, eine monolithisch integrierfähige Halbleiter-Verstärkerschaltung, insbesondere Halbleiter-Leistungsverstärkerschaltung, mit reeller Gegenkopplung der Operationsverstärker anzugeben.

Hierzu ist gemäss der vorliegenden Erfindung eine der eingangs gegebenen Difinition entsprechende Halbleiter-Verstärkerschaltung derart aufgebaut, dass die Verbindung des nichtinvertierenden Eingangs beider Operationsverstärker zum Versorgungspotential über einen zwischen diesem Versorgungspotential und dem Bezugspotential liegenden Spannungsteiler erfolgt, indem dessen Teilerpunkt unter Vermittlung eines in Serie mit den beiden je einem der beiden Operationsverstärker zugeordneten und an derem nichtinvertierenden Eingang liegenden Versorgungswiderständen liegenden gemeinsamen Zwischenwiderstands mit diesen Versorgungswiderständen und damit mit dem nichtinvertierenden Eingang der beiden Operationsverstärker verbunden ist, dass ausserdem bei beiden Operationsverstärkern die Verbindung des invertierenden Signaleingangs zum Teilerpunkt des den Ausgang des betreffenden Operationsverstärkers mit dem Bezugspotential verbindenden Spannungsteilers durch je einen Widerstand gegeben und die Bemessung dieses Widerstands so getroffen ist, dass sein Widerstandswert gleich der Summe des Widerstandswertes des am nichtinvertierenden Eingang des zugehörigen Operationsverstärkers liegenden Versorgungswiderstands und des doppelten Widerstandswertes des gemeinsamen Zwischenwiderstands ist.

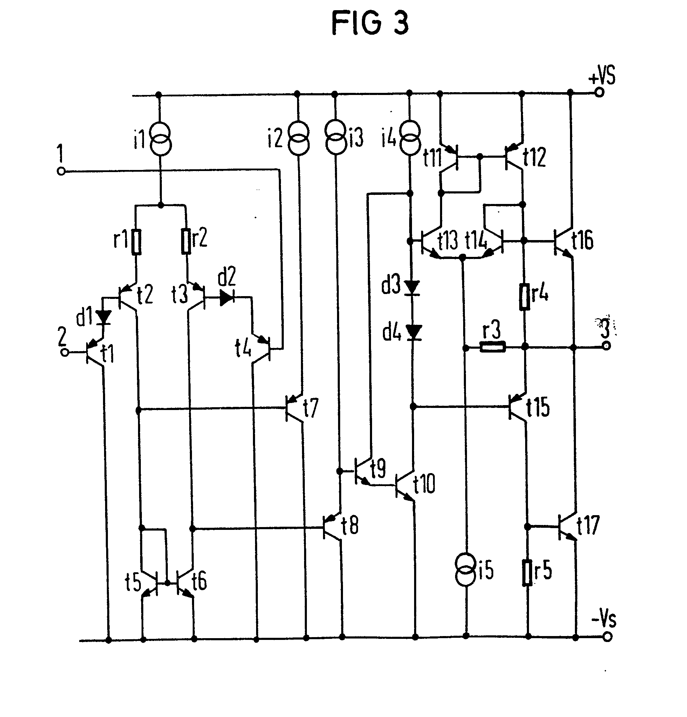

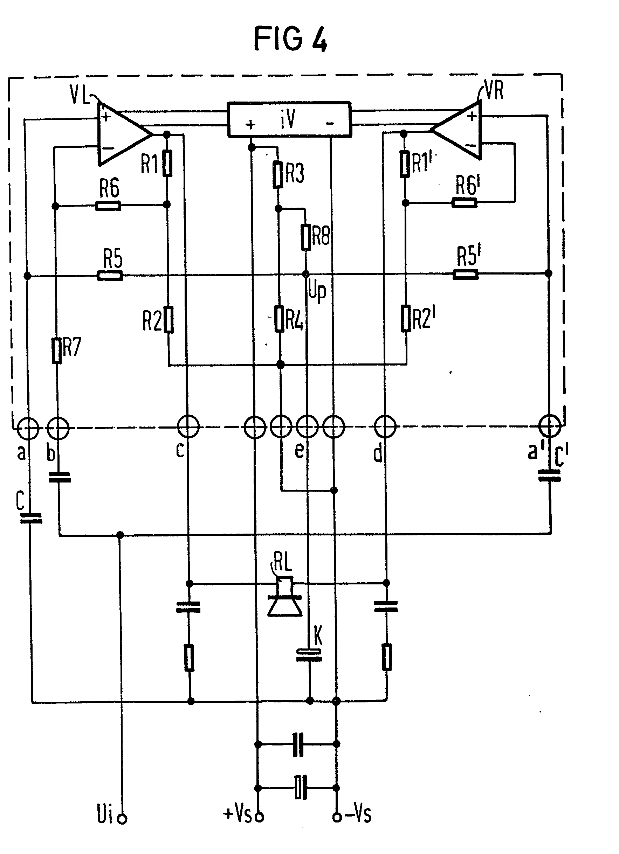

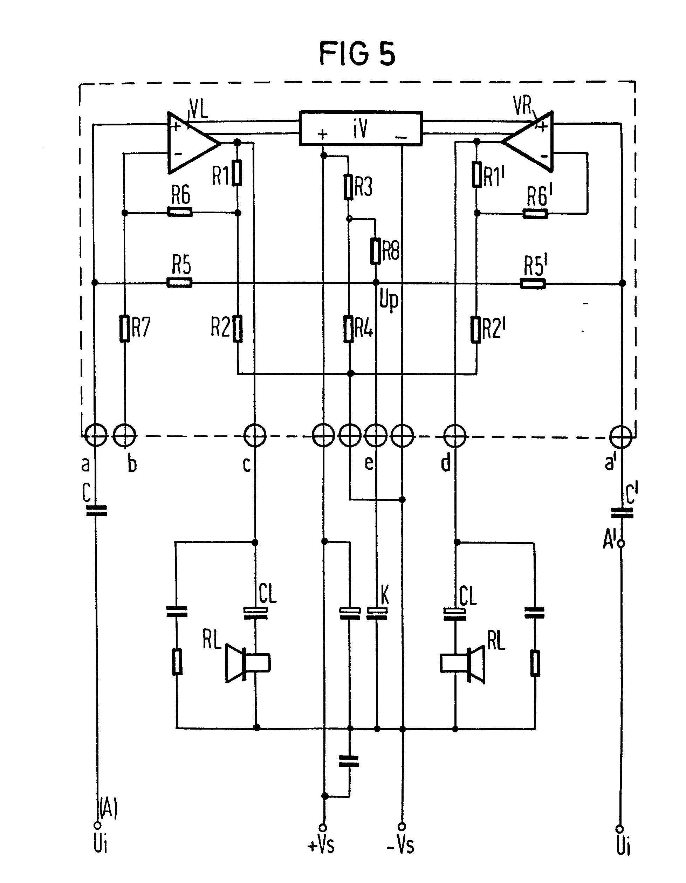

In Figur 2 ist die der Erfindung entsprechende Halbleiterschaltung und in Figur 3 eine geeignete Ausgestaltung für die beiden Operationsverstärker dargestellt, die zweckmässig einander gleich sind. Figur 4 und Figur 5 zeigen die Hauptanwendungsmöglichkeit für eine der Definition der Erfindung entsprechende integrierte Verstärkerschaltung.

Die in Figur 2 dargestellte Ausgestaltung einer Halbleiter-Verstärkerschaltung gemäss der vorliegenden Erfindung zeigt, dass jeder der beiden Operationsverstärker $V_L$ und $V_R$ mit seinem nichtinvertierenden Signaleingang über je einen Versorgungswiderstand $R_5$ bzw. $R_5'$ an ein das Potential $U_P$ führenden gemeinsamen Knoten gelegt ist. Dieser das Potential $U_P$ führende Knoten liegt einerseits über einen Zwischenwiderstand $R_8$ am Teilerpunkt eines Spannungsteilers $R_4$, $R_3$, dessen einer Endanschluss durch das Bezugspotential $-V_s$ und dessen anderer Endanschluss durch das Versorgungspotential $+V_s$ versorgt ist. Andererseits liegt der besagte Knoten mit dem Potential $U_P$ über einen Kondensator K am Bezugspotential $-V_s$. Schliesslich liegt der invertierende Eingang des einen der beiden Operationsverstärkers, im Beispielsfall des Operationsverstärkers $V_L$, über einen Widerstand $R_7$ an einer Signaleingangsklemme b. Insbesondere wenn die Teilerverhältnisse in den beiden zwischen dem Signalausgang der beiden Operationsverstärker $V_L$ und $V_R$ und dem Bezugspotential $-V_s$ liegenden Spannungsteiler einander gleich sind, d.h. also wenn $R_1:R_2 = R_1':R_2'$ ist, empfiehlt es sich im Interesse einer gleichen Verstärkung, dass der zwischen dem invertierenden Verstärkereingang von $V_L$ und dem Signaleingang b liegende Eingangswiderstand $R_7$ gleich dem Gegenkopplungswiderstand $R_6$ bemessen ist.

Angesichts der in Figur 2 dargestellten Schaltung gemäss der Erfindung lässt sich nun folgendes feststellen: Die Widerstände $R_1$, $R_2$ beim einen Operationsverstärker $V_L$ und die Widerstände $R_1'$, $R_2'$ beim zweiten Operationsverstärker bilden in ersichtlicher Weise die Gegenkopplungsteiler. Die Polarisationsspannung $U_P$ am Knoten zwischen den beiden Versorgungswiderständen $R_5$ und $R_5'$ wird durch den Spannungsteiler $R_3$, $R_4$ und dem Zwischenwiderstand $R_8$ erzeugt. Im allgeimeinen sind die beiden Operationsverstärker $V_R$ und $V_L$, wie bereits bemerkt, einander gleich und zwar sowohl im Aufbau als auch in der Bemessung. Es ist dabei auf jeden Fall günstig, wenn man auf eine möglichst geringe Offsetspannung der beiden Operationsverstärker $V_L$ und $V_R$ achtet. Zudem muss der Gleichtaktbereich der beiden Operationsverstärker bis zum Bezugspotential, also bis $-V_s$, reichen.

Liegt am Signaleingang A oder am Signaleingang A' die Spannung $U_i = O$, so soll am Ausgang jedes der beiden Operationsverstärker $V_L$ und $V_R$ somit wegen der extrem niedrigen Offsetspannung die auf das Bezugspotential $-V_s$ bezogene Ausgangsspannung $U_a$ der Beziehung $U_a = O$ genügen.

Weiter wird man in der Praxis auch dafür sorgen, dass bei übereinstimmenden Operationsverstärkern $V_L$ und $V_R$ auch die beiden Spannungsteiler $R_1$, $R_2$ und $R_1'$, $R_2'$ einander gleich sind, wie bereits angedeutet wurde.

Mit der Verstärkung des Systems, d.h. des jeweiligen Operationsverstärkers inklusive seiner Gegenkopplung, die durch die Beziehung

$$V_u = 1 + R_1/R_2,$$

die für eine Leerlaufverstärkung der beiden Operationsverstärker gilt, die gross gegenüber $V_u$ ist, erhält man für das Potential $U_P$ am Knoten zwischen den beiden Versorgungswiderständen $R_5$ und $R_5'$ die Beziehung

$$U_p = V_{s/2} \cdot R_2/(R_1 + R_2).$$

Wählt man nun $R_1 = R_3$, so sind für die Widerstände $R_2$ und $R_4$ die Werte

$$R_2 = R_1/(V_u - 1) \text{ und } R_4 = R_1 \cdot R_2/(2R_1 + R_2)$$

bestimmt, wobei

$$V_u - 1 + R_1/R_2$$

ist. Die Versorgungswiderstände $R_5$ und $R_5'$ stellen bezüglich der Klemmen A, A' den Wechselspannungs-Eingangswiderstand der Schaltung dar. Mit $R_6$ bzw. $R_6'$ wird der Spannungsabfall am Versorgungswiderstand $R_5$ bzw. $R_5'$ und am Zwischenwiderstand $R_8$ kompensiert. Da die Eingangströme der beiden Operationsverstärker einander gleich sind, gilt $R_6 = R_5 + 2 R_8$ bzw. $R_6' = R_5' + 2 R_8$.

Der Kondensator K verbindet den Knoten zwischen den beiden Versorgungswiderständen $R_5$ und $R_5'$ mit dem Bezugspotential $-V_s$. Seine Aufgabe ist, die Polarisationsspannung $U_P$, die aufgrund der aus Figur 2 ersichtlichen Anschaltung des besagten Knotens entsteht, zu sieben. Er bestimmt ausserdem im wesentlichen das Einschaltverhalten.

Bei einer monolithischen Realisierung der erfindungsgemässen Verstärkerschaltung sind sowohl die beiden Verstärker $V_L$ und $V_R$ als auch die Gesamtheit der aus Figur 2 ersichtlichen Widerstände auf einem gemeinsamen Chip vereinigt. Lediglich die Konsensatoren C, C' und K sind extern. Die Integration wird erst aufgrund der von der Erfindung vorgeschlagenen Bemessung für die Gegenkopplungswiderstände $R_6$ und $R_6'$ möglich.

Allerdings ist dabei noch zu beachten, dass die angegebene Bedingung für die Bemessung von $R_6$ und $R_6'$ vor allem die Aufgabe hat, den Offset des zugehörigen Verstärkers $V_L$ bzw. $V_R$ zu unterdrücken. Da aber andererseits der Gegenkopplungswiderstand $R_6$ bzw. $R_6'$ mit wachsendem Widerstandswert das Rauschverhalten sowie die Unterdrückung des Netzbrummens nachteilig beeinflusst, ist es gemäss der weiteren Erfindung angebracht, wenn man den zugleich die Funktion eines Eingangswiderstandes ausübenden Versorgungswiderstand $R_5$ bzw. $R_5'$ bei den beiden Operationsverstärkern $V_L$ und $V_R$ so niedrig einstellt, dass sich der Einfluss des Gegenkopplungswiderstands $R_6$ bzw. $R_6'$ auf das Rauschverhalten und die Unterdrückung des Netzbrummens nicht mehr bemerkbar machen kann. Man stellt deshalb den Widerstandswert jedes der beiden Versorgungswiderstände $R_5$ und $R_5'$ so ein, dass er im Bereich von 10–30 kΩ, insbesondere bei 20 kΩ, liegt. Durch den Einsatz von offsetarmen Operationsverstärkern und bei Verstärkungen um 30 dB ist ein Offsetabgleich nicht erforderlich, da die Offsetspannung der Verstärker mit der Verstärkung $V_u = 1 + R_1/R_2$ am Ausgang erscheint (also mitverstärkt wird).

Eine der Erfindung entsprechende Verstärkerschaltung lässt sich einerseits als Brückenverstärkerschaltung und andererseits als Stereoverstärker betreiben. Die erste Möglichkeit ist in Figur 4, die zweite in Figur 5 dargestellt, wobei in beiden Fällen von der in Figur 2 dargestellten Verstärkerschaltung ausgegangen wird.

Will man die in Figur 2 dargestellte Schaltung in Brückenschaltung betreiben, so legt man den Eingang A bzw. a an das Bezugspotential $-V_s$ (Masse) und schaltet den invertierenden Eingang desjenigen der beiden Verstärker, der über den Widerstand $R_7$ an die Signaleingangsklemme b angeschlossen ist, also des Verstärkers $V_L$, über einen Kondensator an den durch das Eingangssignal $U_i$ zu beaufschlagenden Eingang der Verstärkerschaltung. Gleichzeitig liegt der nichtinvertierende Eingang des anderen Operationsverstärkers, also des Verstärkers $V_R$, ebenfalls über einen Kondensator, an dem besagten Eingang $U_i$ der Verstärkerschaltung. Der zuletzt genannte Kondensator ist der Kondensator C' in Figur 2. Mit dem Widerstand $R_6$ und $R_7$ wird dann, weil $R_6 = R_7$ ist, der Gegenkopplung eines invertierenden Verstärkers die Elektrometer-Gegenkopplung überlagert. Man erhält dann bei Phasenumkehr dieselbe Verstärkung wie im nichtinvertierenden Betrieb.

Für die Bemessung der in Figur 2 vorgesehenen Widerstände sind folgende – bequem integrierbare – Werte besonders günstig:

$R_1 = R_1' = R_3 = 15,3 \text{ k}\Omega; R_2 = R_2' = 500 \ \Omega;$
$R_6 = R_6' = R_7 = 22 \text{ k}\Omega; R_5 = R_5' = 20 \text{ k}\Omega;$
$R_4 = 246 \ \Omega \text{ und } R_8 = 1 \text{ k}\Omega.$

Der Verstärkungsgrad der beiden Verstärker $V_L$ und $V_R$ ist auf den Wert $(1 + R_1/R_2) \triangleq 30 \text{ dB}$ eingestellt. Es bereitet also keine Schwierigkeiten, die soeben angegebenen Widerstände mit den beiden Verstärkern $V_L$ und $V_R$ monolithisch zusammenzufassen, wenn man die üblichen Regeln der Integration, beispielsweise das Verhindern thermischer und elektrischer Verkopplungen, berücksichtigt.

Der der Siebung dienende Kondensator K ist hingegen extern und hat eine Kapazität von 100 µF. Er wird, wie die Figuren 4 und 5 zeigen, sowohl beim Betrieb als Brückenschaltung als auch beim Betrieb als Stereoverstärker gebraucht. Seine Siebwirkung wird durch den Widerstand $R_8$ (also den Zwischenwiderstand) entscheidend erhöht.

Eine monolithisch realisierbare Schaltung für die beiden Operationsverstärker $V_L$ und $V_R$ ist in Figur 3 dargestellt. Sie verwendet sowohl pnpals auch npn-Transistoren sowie Dioden und Widerstände.

Der nichtinvertierende Eingang 1 eines solchen Verstärkers steuert die Basis eines pnp-Transistors t4, dessen Kollektor am Bezugspotential $-V_s$ und dessen Emitter an der Kathode einer Diode d2 und über diese Diode an der Basis eines weiteren pnp-Transistors t3 liegt. Der invertierende Eingang 2 entspricht in seiner Schaltung der des nichtinvertierenden Eingangs 1. Er bildet also den Basisanschluss eines dritten pnp-Transistors t1, dessen Kollektor ebenfalls am Bezugspotential $-V_s$ und dessen Emitter an der Kathode einer Diode d1 und über diese Diode d1 an der Basis eines vierten pnp-Transistors t2 liegt. Der zweite pnp-Transistor t3 ist über die Reihenschaltung zweier gleicher Widerstände r2, r1 über seinen Emitter mit dem Emitter des vierten pnp-Transistors t2 verbunden. Ausserdem liegt der Verbindungspunkt zwischen den beiden Widerständen r1 und r2 über eine Konstantstromquelle i1 am positiven Anschluss $+V_s$ der Versorgungsspannungsquelle, deren negativer Anschluss das Bezugspotential $-V_s$ liefert.

Der zweite pnp-Transistor t3 ist mit seinem Kollektor mit dem Kollektor eines ersten npn-Transistors t6 verbunden, dessen Emitter am Bezugspotential $-V_s$ und dessen Basis sowohl am Kollektor des pnp-Transistors t2 als auch an der Basis und an dem Kollektor eines weiteren npn-Transistors t5 angeschlossen ist. Der Emitter dieses npn-Transistors t5 liegt unmittelbar am Bezugspotential $-V_s$. Am Bezugspotential $-V_s$ liegt ausserdem der Kollektor des pnp-Transistors t1 und des pnp-Transistors t4, wie bereits oben bemerkt wurde.

Sowohl der Kollektor des zweiten pnp-Transistors t3 als auch der Kollektor des vierten pnp-Transistors t2 steuert die Basis jeweils eines weiteren pnp-Transistors t7 bzw. t8. Der Emitter des vom vierten pnp-Transistor t2 gesteuerten pnp-Transistors t7 liegt dabei über eine Stromquelle i2 am Versorgungspotential $+V_s$ und mit seinem Kollektor am Bezugspotential $-V_s$. Der Emitter des vom zweiten pnp-Transistor t3 gesteuerten pnp-Transistors liegt über eine weitere Stromquelle i3 am Versorgungspotential und mit seinem Kollektor ebenfalls am Bezugspotential. Zum Unterschied gegenüber dem Transistor t7 liegt jedoch der Emitter des pnp-Transistors t8 an der Basis des dritten npn-Transistors t9, dessen Emitter-Kollektorstrecke von der Serienschaltung zweier gleichsinnig gepolter Dioden d3, d4 und der Basis-Kollektordiode eines vierten npn-Transistors t10 überbrückt ist. Hierzu liegt der Kollektor des dritten npn-Transistors t9 einerseits über eine vierte Konstantstromquelle i4 am Versorgungspotential $+V_s$ und andererseits an der Anode der Diode d3. Die Kathode dieser Diode d3 liegt an der Anode der Diode d4, deren Kathode mit dem Kollektor des vierten npn-Transistors t10 verbunden ist. Die Basis des vierten npn-Transistors t10 liegt am Emitter des dritten npn-Transistors t9. Der Emitter des vierten npn-Transistors t10 ist an das Bezugspotential $-V_s$ gelegt, während sein Kollektor neben den bereits genannten Verbindungen noch eine unmittelbare Verbindung mit der Basis eines siebenten pnp-Transistors t15 aufweist. Zu erwähnen ist schliesslich noch, dass der Kollektor des dritten npn-Transistors t9 noch an die Basis eines fünften npn-Transistors t13 gelegt ist.

Der zuletzt genannte npn-Transistor t13 bildet zusammen mit einem sechsten npn-Transistor t14 einen emittiergekoppelten Differenzverstärker, dessen beide Emitter über eine fünfte Stromquelle i5 an das Bezugspotential $-V_s$ gelegt ist. Der Kollektor des fünften npn-Transistors t13 liegt an der Basis und am Kollektor eines achten pnp-Transistors t11, der mit seinem Emitter am Versorgungspotential $+V_s$ und mit seiner Basis und seinem Kollektor ausserdem noch an der Basis eines neunten pnp-Transistors t12 liegt. Dieser pnp-Transistor wird an seinem Emitter unmittelbar durch das Versorgungspotential $+V_s$ beaufschlagt und ist mit seinem Kollektor unmittelbar mit dem Kollektor und der Basis des sechsen npn-Transistors t14 verbunden.

Zwei weitere npn-Transistoren t16 und t17 sind bezüglich ihrer Emitter-Kollektorstrecke in Reihe geschaltet. Dabei liegt der Kollektor des siebten npn-Transistors t16 am Versorgungspotential $+V_s$ und sein Emitter am Signalausgang 3 des Einzelverstärkers. Andererseits ist der Emitter des achten npn-Transistors t17 unmittelbar mit dem Anschluss für das Bezugspotential $-V_s$ verbunden, während sein Kollektor am Signalausgang 3 des Verstärkers liegt. Die Basis des achten npn-Transistors t17 ist mittels eines Widerstands r5 mit dem Bezugspotential $-V_s$ und ausserdem mit dem Kollektor des siebten pnp-Transistors t15 verbunden. Die Basis des siebten npn-Transistors t16 hingegen ist über einen Widerstand r4 sowohl mit dem Signalausgang 3 des Einzelverstärkers als auch mit dem Emitter des siebenten pnp-Transistors t15 verbunden. Ausserdem liegt die Basis des siebenten npn-Transistors t16 am Kollektor und an der Basis des sechsten npn-Transistors t14. Schliesslich ist noch zu erwähnen, dass der Signalausgang 3 des Einzelverstärkers über einen Widerstand r3 mit dem Emitter des fünften bzw. des sechsten npn-Transistors t13 bzw. t14 verbunden ist. Der pnp-Transistor t7 hat die Aufgabe, den Basisstrom des pnp-Transistors t8 zu kompensieren.

Die in Figur 3 dargestellte bevorzugte Ausgestaltung für die beiden Operationsverstärker $V_L$ und $V_R$ bringt folgende wesentliche Vorteile:

a) mit den Dioden d1 und d2 wird der Gleichtaktbereich der Eingangsklemmen 1 und 2 bis auf $-V_s$ sichergestellt;

b) die Offsetminimalisierung erreicht man dann durch folgende Massnahmen:

1.) die Basisströme der Transistoren t5 und t6 kompensiert man für die typische Stromverstärkung über das Emitter-Flächenverhältnis von t5 und t6;

2.) der Basisstrom von t8 wird, wie bereits angedeutet, durch den Basisstrom eines gleichen pnp-Transistors t7 kompensiert, der den gleichen Kollektorstrom wie t8 führt. Es muss also i2 = i3 gelten.

Die unter a) und b) genannten Vorteile kommen vor allem auch bei der Verwendung von Operationsverstärkern, die gemäss Figur 3 ausgestaltet sind, in der erfindungsgemässen Schaltung entsprechend Figur 2 zur Geltung.

In Figur 4 ist die Anwendung einer entsprechend Figur 2 ausgestalteten integrierten Schaltung als Brückenverstärker gezeigt. Das zu betreibende Lastelement $R_L$, z.B. ein Lautsprecher, ist mit seinem einen Signaleingang mit dem Anschluss c und mit dem anderen Signaleingang mit dem Anschluss d einer Schaltung gemäss Figur 2 verbunden. Ferner liegt der Anschluss a sowie der Anschluss a' dieser Schaltung über je einen Kondensator mit 100 µF Kapazität an dem durch das zu verstärkende Signal Ui beaufschlagten Eingang der Gesamt-Verstärkerschaltung. (Der an dem Pin a' liegende Kondensator ist der Kondensator C' in Figur 2.). Der das Versorgungspotential $+V_s$ liefernde Pol der Versorgungsspannungsquelle ist mit dem das Bezugspotential $-V_s$ liefernden Pol über einen Kondensator von 1000 µF verbunden. Diesem Kondensator ist ein weiterer Kondensator von 100 nF parallel geschaltet. Ferner ist der das Versorgungspotential $+V_s$ liefernde Pol der Versorgungsspannungsquelle an die entsprechende (nicht näher bezeichnete) Versorgungsklemme der integrierten Verstärkerschaltung gelegt, während der das Bezugspotential $-V_s$ liefernde Pol der Versorgungsspannungsquelle an zwei Versorgungsklemmen der integrierten Schaltung gelegt ist. Schliesslich sind die beiden Signaleingänge des Lastelements $R_L$ über je einen Kondensator von 100 nF an je einen Widerstand von 1 Ohm und dieser an das Bezugspotential $-V_s$ liefernden Anschluss der Versorgungsspannungsquelle gelegt. Schliesslich ist auch mit diesem Pol der Versorgungsspannungsquelle noch der bereits im Zusammenhang mit Figur 2 eingeführte und eine Kapazität von 100 µF aufweisende Siebkondensator K verbunden, dessen anderer Anschluss über den Pin e im Inneren des IC's mit dem das Potential $U_P$ führenden Knoten verbunden ist.

Im Inneren der integrierten Verstärkerschaltung ist ein Schaltungsteil iV vorgesehen, welcher die Versorgungspannung an die beiden Operationsverstärker $V_L$ und $V_R$ weitergibt. Im einfachsten Fall reduziert sich dieser Schaltungsteil iV auf die zu den beiden OP's führenden internen leitenden Verbindungen. Dabei ist nun zu bemerken, dass der eine der beiden das Bezugspotential $-V_s$ führenden Pin des IC's lediglich zur Versorgung der nichtinvertierenden Signaleingänge der beiden Operationsverstärker $V_L$ und $V_R$ dient und demnach im Inneren des IC's an den Widerstand $R_4$ des Spannungsteilers $R_3$, $R_4$ angeschlossen ist, sowie das Bezugspotential $-V_s$ für die beiden Gegenkopplungsspannungsteiler $R_1$, $R_2$ bzw. $R_1'$, $R_2'$ zu liefern hat. Der zweite das Bezugspotential $-V_s$ führende Anschlusspin liefert das z.B. bei der Schaltung gemäss Figur 3 benötigte Bezugspotential $-V_s$.

Die in Figur 5 dargestellte Anordnung zeigt die Ausgestaltung der externen Beschaltung der integrierten Verstärkerschaltung gemäss der Erfindung im Falle der Verwendung als Stereoverstärker.

Hier liegt das zu verarbeitende Eingangssignal Ui über den Kondensator C am Signaleingangspin a und am Signaleingangspin a', während der Signaleingang b keine Beaufschlagung erfährt. Die das Versorgungspotential $+V_s$ liefernde

Klemme der Versorgungsquelle liegt am gleichen Versorgungspin wie im Falle der Figur 4. Ausserdem ist sie über einen Kondensator von 100 nF mit dem einen Anschluss sowohl des Siebkondensators K als auch der beiden – einander gleichen und z.B. durch je einen Lautsprecher gegebenen – Lastelemente $R_L$ verbunden. Beide Lastelemente sind unter Vermittlung je eines eine Kapazität z.B. von etwa 1000 µF aufweisenden Kondensators CL mit je einem der zu je einem der Ausgänge der beiden Operationsverstärker $V_L$ und $V_R$ führenden Ausgangspins c bzw. d des IC's verbunden. Ausserdem sind beide Lastelemente $R_L$ samt dem zugehörigen Kondensator CL von je einer Reihenschaltung eines Kondensators von 100 nF und eines Widerstands von 1 Ohm überbrückt, wobei der Kondensator am Kondensator CL und der Widerstand am Lastelement $R_L$ liegt. Schliesslich ist noch ein weiterer Kondensator mit einer Kapazität von 1000 µF vorgesehen, der zusammen mit einem bereits erwähnten Kondensator den Eingang für das Versorgungspotential $+V_s$ mit dem einen Signalanschluss der beiden Lastelemente $R_L$ verbindet und daher dem erstgenannten Kondensator parallel geschaltet ist.

Einzelheiten über die Wirkung der in Figur 4 bzw. in Figur 5 dargestellten Anwendung der erfindungsgemässen Verstärkerschaltung sind bereits oben gebracht worden.

**Patentansprüche**

1. Halbleiter-Verstärkerschaltung, insbesondere Halbleiter-Leistungsverstärkerschaltung, mit einem ersten und einem zweiten Operationsverstärker ($V_L$, $V_R$) bei der die Gegenkopplung bei beiden Operationsverstärkern als reelle Gegenkopplung ausgebildet ist, wobei der Ausgang (c, d) jedes dieser beiden Operationsverstärker über je einen aus zwei hintereinandergeschalteten Widerständen ($R_1$, $R_2$; $R_1'$, $R_2'$) bestehenden Spannungsteiler mit dem Bezugspotential ($-V_S$), z.B. Masse, verbunden ist und ausserdem eine Verbindung ($R_6$) des Teilerpunktes des betreffenden Spannungsteilers mit dem invertierenden Signaleingang (−) des jeweils zugehörigen Operationsverstärkers vorgesehen ist, bei der der invertierende Signaleingang (−) des einen Operationsverstärkers ($V_L$) über einen weiteren Widerstand ($R_7$) mit einem weiteren Signaleingang (b) verbunden ist, und bei der der nichtinvertierende Signaleingang (+) der beiden Operationsverstärker ($V_L$, $V_R$) an je eine Signaleingangsklemme (A, A') der Verstärkerschaltung gelegt und über je einen Versorgungswiderstand ($R_5$, $R_5'$) mit Versorgungspotential beaufschlagt ist, dadurch gekennzeichnet, dass die Verbindung des nichtinvertierenden Eingangs (+) beider Operationsverstärker ($V_L$, $V_R$) zum Versorgungspotential ($+V_S$) über einen zwischen diesem Versorgungspotential ($+V_S$) und dem Bezugspotential ($-V_S$) liegenden, gemeinsamen Spannungsteiler ($R_3$, $R_4$) erfolgt, indem dessen Teilerpunkt mit einem in Serie mit den beiden an den nichtinvertierenden Eingang (+) angeschlossenen Versorgungswiderständen ($R_5$, $R_5'$) liegenden, gemeinsamen Zwischenwiderstand ($R_8$) verbunden ist, dass bei beiden Operationsverstärkern ($V_L$, $V_R$) die Verbindung des invertierenden Signaleingangs (−) mit dem Teilerpunkt des ausgangsseitigen Spannungsteilers ($R_1$, $R_2$; $R_1'$, $R_2'$) durch einen Widerstand ($R_6$, $R_6'$) gebildet und die Bemessung dieses Widerstandes ($R_6$, $R_6'$) so getroffen ist, dass sein Widerstandswert gleich der Summe des Widerstandswertes des am nichtinvertierenden Eingang (+) des zugehörigen Operationsverstärkers ($V_L$, $V_R$) liegenden Versorgungswiderstands ($R_5$, $R_5'$) und des doppelten Widerstandswerts des gemeinsamen Zwischenwiderstands ($R_8$) ist.

2. Halbleiter-Verstärkerschaltung nach Anspruch 1, dadurch gekennzeichnet, dass die beiden Operationsverstärker ($V_L$, $V_R$) im Aufbau und in der Bemessung sowie in der Bemessung ihrer Gegenkopplungswiderstände ($R_1$, $R_1'$; $R_2$, $R_2'$; $R_6$, $R_6'$) und Versorgungswiderstände ($R_5$, $R_5'$) einander gleich sind.

3. Halbleiter-Verstärkerschaltung nach Anspruch 1 oder 2, dadurch gekennzeichnet, dass dem invertierenden Eingang (−) des einen der beiden Operationsverstärker ($V_L$) das Eingangssignal über den weiteren Widerstand ($R_7$) zuführbar ist.

4. Halbleiter-Verstärkerschaltung nach Anspruch 3, dadurch gekennzeichnet, dass der für die Steuerung des invertierenden Signaleingangs benötigte weitere Widerstand ($R_7$) den gleichen Widerstandswert aufweist, wie der an diesem Signaleingang liegende Gegenkopplungswiderstand ($R_6$)

5. Halbleiter-Verstärkerschaltung nach einem der Ansprüche 1 bis 4, dadurch gekennzeichnet, dass die beiden Operationsverstärker ($V_L$, $V_R$) sowie die zu ihrer Beaufschlagung vorgesehenen Widerstände ($R_1$, $R_1'$; $R_2$, $R_2'$; $R_6$, $R_6'$, $R_3$, $R_4$; $R_8$; $R_5$, $R_5'$) monolithisch in einem einzigen Chip zusammengefasst sind.

**Revendications**

1. Circuit amplificateur à semiconducteurs, notamment circuit amplificateur de puissance à semiconducteurs, comportant un premier et un second amplificateurs opérationnels ($V_L$, $V_R$) et dans lequel la contre-réaction est réalisée sous la forme d'une contre-réaction réelle dans les deux amplificateurs opérationnels, et dans lequel la sortie (c, d) de chacun de ces deux amplificateurs opérationnels est reliée par l'intermédiaire d'un diviseur de tension respectif constitué par deux résistances ($R_1$, $R_2$; $R_1'$, $R_2'$) branchés en série, au potentiel de référence ($-V_S$), par exemple la masse, et en outre il est prévu une liaison ($R_6$) du point de division du diviseur de tension considéré à l'entrée inverseuse du signaux (−) de l'amplificateur opérationnel respectivement associé, et dans lequel l'entrée inverseuse du signaux (−) de l'amplificateur opérationnel ($V_L$) est reliée par l'intermédiaire d'une autre résistance ($R_7$) à une autre entrée de signaux (b), et dans lequel l'entrée non inverseuse des signaux (+) des deux amplificateurs opérationnels ($V_L$, $V_R$) est raccordée à une borne respective d'entrée de signaux (A, A') du circuit amplificateur et est chargée par l'intermédiaire d'une résistance respective d'alimentation ($R_5$, $R_5'$) à un potentiel d'alimentation, caractérisé par le fait que la liaison de l'entrée non inverseuse (+) des deux amplificateurs opérationnels ($V_L$, $V_R$) au potentiel d'alimentation (+$V_S$) est réalisée par l'intermédiaire d'un diviseur de tension commun ($R_3$, $R_4$) situé entre ce potentiel d'alimentation (+$V_S$) et le potentiel de référence (–$V_S$), par le fait que le point de division de ce diviseur est relié à une résistance intermédiaire commune ($R_8$), qui est montée en série avec les deux résistances d'alimentation ($R_5$, $R_5'$) raccordées à l'entrée non inverseuse (+), que, dans les deux amplificateurs opérationnels ($V_L$, $V_R$), la liaison de l'entrée inverseuse des signaux (–) au point de division du diviseur de tension ($R_1$, $R_2$; $R_1'$, $R_2'$) située du côté sortie, est formée par une résistance ($R_6$, R') et que le dimensionnement de cette résistance ($R_6$, $R_6'$) est tel que la valeur résistive est égale à la somme de la valeur résistive de la résistance d'alimentation ($R_5$, $R_5'$), reliée à l'entrée non inverseuse (+) de l'amplificateur opérationnel associé ($V_L$, $V_R$) et du double de la valeur résistive de la résistance intermédiaire commune ($R_8$).

2. Circuit amplificateur à semiconducteurs suivant la revendication 1, caractérisé par le fait que les deux amplificateurs opérationnels ($v_L$, $V_R$) sont identiques du point de vue de leur constitution, de leur dimensionnement ainsi que du dimensionnement de leurs résistances de contre-réaction ($R_1$, $R_1'$; $R_2$, $R_2'$; $R_6$, $R_6'$) et de leurs résistances d'alimentation ($R_5$, $R_5'$).

3. Circuit amplificateur à semiconducteurs suivant la revendication 1 ou 2, caractérisé par le fait que le signal d'entrée peut être envoyé par l'intermédiaire de l'autre résistance ($R_7$) à l'entrée inverseuse (–) de l'un des deux amplificateurs opérationnels ($V_L$).

4. Circuit amplificateur à semiconducteurs suivant la revendication 3, caractérisé par le fait que l'autre résistance ($R_7$), qui est nécessaire pour la commande de l'entrée inverseuse des signaux, possède la même valeur résistive que la résistance de contre-réaction ($R_6$) raccordée à cette entrée des signaux.

5. Circuit amplificateur à semiconducteurs selon l'une des revendications 1 à 4, caractérisé par le fait que les deux amplificateurs opérationnels ($V_L$, $V_R$) ainsi que les résistances ($R_1$, $R_1'$, $R_2$, $R_2'$, $R_6$, $R_6'$, $R_3$, $R_4$, $R_8$; $R_5$, $R_5'$) prévues pour le chargement de ces amplificateurs sont réunies sous forme monolithique dans une microplaquette unique.

## Claims

1. A semiconductor amplifier circuit, in particular a semiconductor power amplifier circuit, comprising a first and a second operational amplifier ($V_L$, $V_R$), where the negative feedback of the two operational amplifiers comprises a real negative feedback, where the output (c, d) of each of these two operational amplifiers is connected via a voltage divider, comprising two series-connected resistors ($R_1$, $R_2$; $R_1'$, $R_2'$), to the reference potential (–$V_S$), e.g. earth, and a connection ($R_6$) is also provided between the divider point of the relevant voltage divider to the inverting signal input (–) of the associated operational amplifier, where the inverting signal input (–) of the first operational amplifier ($V_L$) is connected via a further resistor ($R_7$) to a further signal input (b), and where the non-inverting signal input (+) of the two operational amplifiers ($V_L$, $V_R$) is in each case connected to a signal input terminal (A, A') of the amplifier circuit and is in each case connected to supply potential via a supply resistor ($R_5$, $R_5'$), characterised) in that the connection between the non-inverting input (+) of the two operational amplifiers ($V_L$, $V_R$) and the supply potential (+$V_S$) is effected via a common voltage divider ($R_3$, $R_4$), which is located between this supply potential (+$V_S$) and the reference potential (–$V_S$), in that the divider point of said voltage divider is connected to a common intermediate resistor ($R_8$) which is arranged in series with the two supply resistors ($R_5$, $R_5'$) which are connected to the non-inverting input (+), that in both operational amplifiers ($V_L$, $V_R$) the connection between the inverting signal input (–) and the divider point of the output-end voltage divider ($R_1$, $R_2$; $R_1'$, $R_2'$) is formed by a resistor ($R_6$, $R_6'$) and this resistor ($R_6$, $R_6'$) is contrived to be such that its resistance value is equal to the sum of the resistance value of the supply resistor ($R_5$, $R_5'$) connected to the non-inverting input (+) of the associated operational amplifir ($V_L$, $V_R$) and double the resistance value of the common intermediate resistor ($R_8$).

2. A semiconductor amplifier circuit as claimed in claim 1, characterised in that the two operational amplifiers ($V_L$, $V_R$) are identical to one another in terms of construction and in terms of dimensioning, and in terms of the dimensioning of their negative feedback resistors ($R_1$, $R_1'$; $R_2$, $R_2'$; $R_6$, $R_6'$) and their supply resistors ($R_5$, $R_5'$).

3. A semiconductor amplifier circuit as claimed in claim 1 or 2, characterised in that the input signal can be supplied via the further resistor ($R_7$) to the inverting input (–) of one of the two operational amplifiers ($V_L$).

4. A semiconductor amplifier circuit as claimed in claim 3, characterised in that the further resistor ($R_7$), which is required for controlling the inverting signal input, has the same resistance value as the negative feedback resistor ($R_6$) which is connected to this signal input.

5. A semiconductor amplifier circuit as claimed in one of the claims 1 to 4, characterised in that the two operational amplifiers ($V_L$, $V_R$) and the resistors ($R_1$, $R_1'$; $R_2$, $R_2'$; $R_6$, $R_6'$, $R_3$, $R_4$; $R_8$; $R_5$, $R_5'$) which serve to supply them are monolitically combined in one single chip.

1/4

FIG 1

FIG 2

2/4

FIG 3

FIG 4

# FIG 5